# EUROPEAN PATENT SPECIFICATION

(11) **EP 3 480 954 B1**
(45) Date of publication and mention of the grant of the patent: **14.10.2020**
(21) Application number: 18203875.2
(22) Date of filing: 31.10.2018
(51) Int. Cl.: H03K 5/135

(54) **PHASE DETECTOR**
PHASENDETEKTOR
DÉTECTEUR DE PHASE

(30) Priority: 06.11.2017 US 201762581890 P; 30.10.2018 US 201816175194
(43) Date of publication of application: 08.05.2019
(73) Proprietor: Qorvo US, Inc., Greensboro, NC 27409 (US)
(72) Inventor: Van Driest, Hans, 25 17 EL The Hague (NL)
(74) Representative: Hanna Moore + Curley

(56) References cited:
- US-A1- 2013 216 014
- US-A1- 2017 170 838
- US-B2- 8 611 479

## Description

### Field of the Disclosure

The present disclosure relates to systems and methods for measuring the phase of a signal.

### Background

The phase of a signal provides valuable information that may be useful in several applications. For example, the phase of a wireless communication signal as it is received at multiple antennas may be used to determine an angle of arrival of the wireless communication signal, which indicates a direction from which the wireless communication signal was transmitted relative to a receiver. Conventional systems and methods for measuring the phase of a wireless communication signal rely on a highly linear receiver. However, highly linear receivers are costly both monetarily and in terms of power consumption. Accordingly, phase measurement and thus angle of arrival estimation has been unavailable for low-cost and low-power applications such as Internet of Things (IoT) devices.

US 2013/216014 discloses a clock and data recovery system where input data is received at a first frequency and a reference clock operates at a second frequency. A master phase-locked loop (PLL) comprising a first gated voltage controlled oscillator (GVCO) is configured to align the phases of reference clock and the input data, and provide phase error information and a recovered clock. A second GVCO is controlled by the recovered clock to sample the input data. A frequency alignment loop comprising a feedback path from the second GVCO to the master PLL is configured to use the phase error information to correct a frequency offset between the first frequency and the second frequency.

There remains a need for systems and methods for measuring the phase of a wireless receive signal that are suited to non-linear (e.g., hard limiting) receiver architectures.

### Summary

2. The invention is described by the content of the independent claims. By providing the phase estimate signal based on the edges of the in-phase signal and the quadrature signal, the phase estimate signal may provide a repeatably accurate phase measurement even when the in-phase signal and the quadrature signal are components of a hard-limited wireless communication signal.

Those skilled in the art will appreciate the scope of the present disclosure and realize additional aspects thereof after reading the following detailed description of the preferred embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
Figure 1 illustrates phase detector circuitry according to one embodiment of the present disclosure.
Figure 2 is a graph illustrating the operation of phase detector circuitry according to one embodiment of the present disclosure.
Figure 3 is a flow diagram illustrating a method for estimating the phase of a signal according to one embodiment of the present disclosure.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

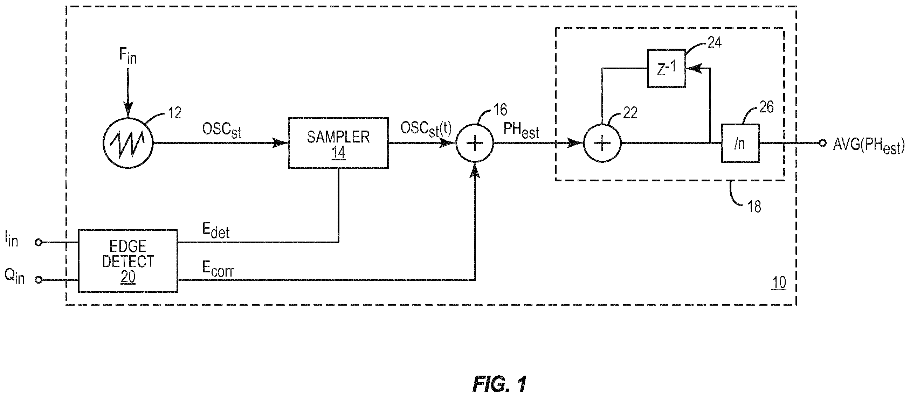

Figure 1 shows phase detector circuitry 10 according to one embodiment of the present disclosure. The phase detector circuitry 10 includes oscillator circuitry 12, sampler circuitry 14 coupled to the oscillator circuitry 12, adder circuitry 16 coupled to the sampler circuitry 14, averaging circuitry 18 coupled to the adder circuitry 16, and edge detection and correction circuitry 20 coupled to the sampler circuitry 14 and the adder circuitry 16.

In operation, the oscillator circuitry 12 provides a sawtooth oscillator signal OSCₛₜ with a value that varies between 0 and 360 at a frequency determined by an input frequency signal Fᵢₙ. The edge detection and correction circuitry 20 receives an in-phase signal Iᵢₙ and a quadrature input signal Qᵢₙ and provides an edge detection signal E_{det} and an edge correction signal E_{corr}. The edge detection signal E_{det} is provided only during an edge of either of the in-phase signal Iᵢₙ and the quadrature signal Qin. In response to the edge detection signal E_{det}, the sampler circuitry 14 samples the sawtooth oscillator signal OSCₛₜ to provide a sampled sawtooth oscillator signal OSCₛₜ(t) to the adder circuitry 16. The adder circuitry 16 subtracts the edge correction signal E_{corr} from the the sampled sawtooth oscillator signal OSCₛₜ(t) to provide a phase estimate signal PHₑₛₜ.

When the edge detection and correction circuitry 20 detects a rising edge of the in-phase signal Iᵢₙ, the edge correction signal E_{corr} is provided with a value of 180. When the edge detection and correction circuitry 20 detects a falling edge of the in-phase signal Iᵢₙ, the edge correction signal E_{corr} is provided with a value of 0. When the edge detection and correction circuitry 20 detects a rising edge of the quadrature signal Qᵢₙ, the edge correction signal E_{corr} is provided with a value of 270. When the edge detection and correction circuitry 20 detects a falling edge of the quadrature signal Qᵢₙ, the edge correction signal E_{corr} is provided with a value of 90.

The effect of the edge correction signal E_{corr} is to normalize the sampled sawtooth oscillator signal OSCₛₜ(t) for each edge of the in-phase signal Iᵢₙ and the quadrature signal Qᵢₙ. Taking the falling edge of the in-phase signal Iᵢₙ as a reference, those skilled in the art will readily appreciate that the rising edge of the in-phase signal Iᵢₙ will be 180 degrees out of phase, the falling edge of the quadrature signal Qᵢₙ will be 270 degrees out of phase, and the rising edge of the quadrature signal Qᵢₙ will be 90 degrees out of phase with this edge. Accordingly, the phase estimate signal PHₑₛₜ reflects a normalized estimate of the phase at each edge of the in-phase signal Iᵢₙ and the quadrature signal Qᵢₙ.

The averaging circuitry 18 includes an averaging adder 22, a delay 24, and a divider 26. The phase estimate signal PHₑₛₜ is provided to the averaging adder 22, where it is added to one or more previous phase estimates held in the delay 24. The combined phase estimates at the output of the averaging adder 22 are divided by the number of phase estimates to provide an averaged phase estimate AVG(PHₑₛₜ).

While the oscillator circuitry 12, the sampler circuitry 14, the adder circuitry 16, the averaging circuitry 18, and the edge detection and correction circuitry 20 are shown in Figure 1 as separate functional components, those skilled in the art will readily appreciate that the functionality provided thereby may be further separated or combined into any number of different functional components, all of which are contemplated herein.

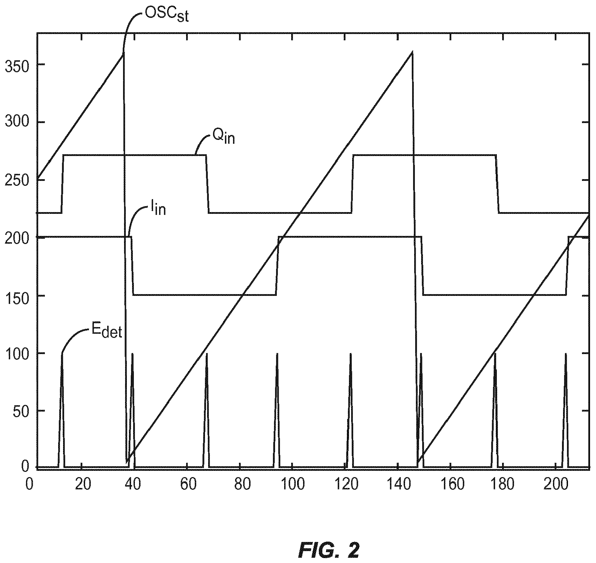

Figure 2 is a graph illustrating the sawtooth oscillator signal OSCₛₜ, the in-phase signal Iᵢₙ, the quadrature signal Qᵢₙ, and the edge detection signal E_{det}. In Figure 2, the Y-axis is representative of signal amplitude while the X-axis is representative of time. Notably, the in-phase signal Iᵢₙ, the quadrature signal Qᵢₙ, and the edge detection signal E_{det} are arbitrarily placed with respect to the Y-axis. As shown, the sawtooth oscillator signal OSCₛₜ has a value that varies between 0 and 360. The in-phase signal Iᵢₙ and the quadrature signal Qᵢₙ are shown as 1-bit quantized signals, as would occur if the in-phase signal Iᵢₙ and the quadrature signal Qᵢₙ were components of a wireless communications signal received by a hard-limiting receiver architecture. In such a case, the in-phase signal Iᵢₙ and the quadrature signal Qᵢₙ are represented as binary signals, in which all information about the phase thereof is contained at the edges thereof. Notably, the edges of the in-phase signal Iᵢₙ and the quadrature signal Qᵢₙ represent zero crossings of the non-quantized and non-limited versions thereof, which would normally be sinusoidal signals. The edge detection signal E_{det} is shown provided at each edge of the in-phase signal Iᵢₙ and the quadrature signal Qᵢₙ.

As shown in Figure 2, at a falling edge of the in-phase signal Iᵢₙ, the value of the sawtooth oscillator signal OSCₛₜ is around 10. At a rising edge of the in-phase signal Iᵢₙ the value of the sawtooth oscillator signal OSCₛₜ is around 190. Subtracting 180 from the value of the sawtooth oscillator signal OSCₛₜ, which is the value of the edge correction signal E_{corr} as provided by the edge detection and correction circuitry 20 during a rising edge of the in-phase signal Iᵢₙ, provides the same value of 10 obtained during the falling edge of the in-phase signal Iᵢₙ. At a rising edge of the quadrature signal Qᵢₙ, the value of the sawtooth oscillator signal OSCₛₜ is around 280. Subtracting 270 from the value of the sawtooth oscillator signal OSCₛₜ, which is the value of the edge correction signal E_{corr} as provided by the edge detection and correction circuitry 20 during a rising edge of the quadrature signal Qᵢₙ, provides the same value of 10 obtained during the falling edge of the in-phase signal Iᵢₙ. Finally, at a falling edge of the quadrature signal Qᵢₙ, the value of the sawtooth oscillator is around 100. Subtracting 90 from the value of the sawtooth oscillator signal OSCₛₜ, which is the value of the edge correction signal E_{corr} as provided by the edge detection and correction circuitry 20 during a falling edge of the quadrature signal Qᵢₙ, provides the same value of 10 obtained during the falling edge of the in-phase signal Iᵢₙ. In this way, a phase estimate may be obtained at each edge of the in-phase signal Iᵢₙ and the quadrature signal Qᵢₙ. While the examples above are given such that the phase estimate at each edge of the in-phase signal Iᵢₙ and quadrature signal Qᵢₙ result in the same value, the values will often be different. The averaging circuitry 18 is thus important to average the difference between the phase estimates at each edge of the in-phase signal Iᵢₙ and the quadrature signal Qᵢₙ such that the averaged phase estimate signal AVG(PHₑₛₜ) more accurately reflects an actual phase of a wireless communication signal composed of the in-phase signal Iᵢₙ and the quadrature signal Qᵢₙ.

While the phase detector circuitry 10 may be operated to sample the in-phase signal Iᵢₙ and the quadrature signal Qᵢₙ for any period of time to provide the averaged phase estimate signal AVG(PHₑₛₜ) for any number of edges thereof, in one embodiment at least four phase estimate signals PHₑₛₜ from at least four edges of the in-phase signal Iᵢₙ and the quadrature signal Qᵢₙ are averaged to provide the averaged phase estimate signal AVG(PHₑₛₜ).

As discussed above, the oscillator circuitry 12 operates at a frequency determined by the input frequency Fᵢₙ. While not shown receiving the input frequency Fᵢₙ, the edge detection and correction circuitry 20 may also operate at such a frequency, which determines the sample rate thereof. Those skilled in the art will readily appreciate that the input frequency Fᵢₙ should be chosen to be significantly higher than a frequency of the in-phase signal Iᵢₙ and the quadrature signal Qᵢₙ. In one example, the input frequency Fᵢₙ should be at least two orders of magnitude higher than a frequency of the in-phase signal Iᵢₙ and the quadrature signal Qᵢₙ. For example, if a frequency of the in-phase signal Iᵢₙ and the quadrature signal Qᵢₙ is 1.75 MHz, the input frequency Fᵢₙ may be chosen to be 192 MHz. This means there are 192 / 1.75 samples in each period of the in-phase signal Iᵢₙ and the quadrature signal Qᵢₙ, providing a resolution of approximately 3.3 degrees per sample (360 degrees in each period).

The phase detector circuitry 10 may be especially useful in applications not requiring an absolute measurement of phase, such as for angle of arrival estimation in which only a relative phase between the same wireless communication signal received at different antennas is required. Notably, the phase detector circuitry 10 may be less susceptible to common sources of systematic errors than conventional phase measurement circuitry. Typical sources of systematic errors in conventional phase estimation circuitry include IQ phase offset, in which a deviation from the ideal 90 degrees of phase separation between an in-phase signal and a quadrature signal occur, IQ unbalance, in which there is a difference in gain between the in-phase signal and the quadrature signal, and DC offset in the in-phase signal and the quadrature signal.

With respect to IQ phase offset, this will result in different phase estimate values PHₑₛₜ at the edges of the in-phase signal Iᵢₙ and the quadrature signal Qᵢₙ, which will in turn shift the averaged phase estimate value AVG(PHₑₛₜ). However, this shift is independent of the absolute input phase, and will always give the same phase shift or offset in the measured phase. In applications in which only the relative or difference in phase between signals is required, this fixed phase offset results in no degradation.

With respect to IQ unbalance, this will be of no consequence in a hard-limited receiver in which the in-phase signal Iᵢₙ and the quadrature signal Qᵢₙ are quantized to 1-bit as discussed above, because the hard-limiting results in only two signal levels and thus removes the difference in gain.

With respect to DC offset, while this will have an effect on the duty cycle of the in-phase signal Iᵢₙ and/or the quadrature signal Qᵢₙ, this change is symmetrical and thus will cancel out since both the rising and falling edges are included in the averaged phase estimate signal AVG(PHₑₛₜ).

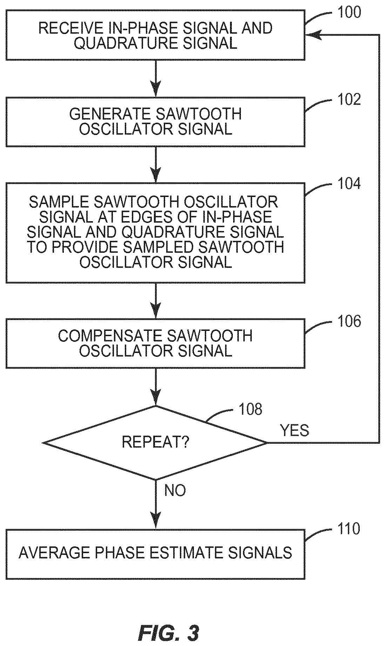

Figure 3 illustrates a method for estimating phase according to one embodiment of the present disclosure. First, an in-phase signal and a quadrature signal are received (step 100). A sawtooth oscillator signal is generated (step 102). The sawtooth oscillator signal is sampled at each edge of the in-phase signal and the quadrature signal (step 104) to provide a sampled sawtooth oscillator signal. The sampled sawtooth oscillator signal is compensated based on whether the edge is on the in-phase signal or the quadrature signal and whether the edge is a rising edge or a falling edge (step 106) to provide a phase estimate signal. Finally, the above process is repeated as many times as desired (step 108), and a number of phase estimate signals are averaged (step 110) to provide an averaged phase estimate signal.

As discussed above, a value of the sawtooth oscillator signal varies between 0 and 360. Further as discussed above, compensating the sampled sawtooth oscillator based on whether the edge is on the in-phase signal or the quadrature signal and whether the edge is a rising edge may be accomplished by not changing the value of the sampled sawtooth oscillator signal when the edge is a falling edge of the in-phase signal, subtracting 180 from the sampled sawtooth oscillator signal when the edge is a rising edge of the in-phase signal, subtracting 270 from the sampled sawtooth oscillator signal when the edge is a rising edge of the quadrature signal, and subtracting 90 from the sampled sawtooth oscillator signal when the edge is a falling edge of the quadrature signal. The in-phase signal and the quadrature signal may be components of a wireless communication signal. In one embodiment, the wireless communication signal is hard-limited, and the in-phase signal and the quadrature signal are quantized to 1-bit signals.

Those skilled in the art will recognize improvements and modifications to the preferred embodiments of the present disclosure. All such improvements and modifications are considered within the scope of the concepts disclosed herein and the claims that follow.

## Claims

1. Phase detector circuitry (10) configured to measure a phase of a signal, the phase detector circuitry (10) comprising:
• oscillator circuitry (12) configured to provide a sawtooth oscillator signal (OSCₛₜ);
• edge detection and correction circuitry (20) configured to:
• receive an in-phase signal (Iᵢₙ) and a quadrature signal (Qᵢₙ);
• provide an edge detection signal (E_{det}) during each edge of the in-phase signal and the quadrature signal; and
• provide an edge correction signal (E_{corr}), wherein the edge correction signal is based on whether the edge is in the in-phase signal or the quadrature signal and whether the edge is a rising edge or a falling edge;
• sampler circuitry (14) coupled to the oscillator circuitry and the edge detection and correction circuitry, the sampler circuitry configured to sample the sawtooth oscillator signal in response to the edge detection signal; and
• adder circuitry (16) coupled to the sampler circuitry and the edge detection and correction circuitry, the adder circuitry configured to subtract the edge correction signal from the sampled sawtooth oscillator signal (OSCₛₜ(t)) to provide a phase estimate signal (PHₑₛₜ).

2. The phase detector circuitry (10) of claim 1 further comprising averaging circuitry (18) coupled to the adder circuitry (16) and configured to receive and average a number of phase estimate signals to provide an average phase estimate signal (AVG(PHₑₛₜ)).

3. The phase detector circuitry (10) of claim 1 wherein the oscillator circuitry (12) is configured to provide the sawtooth oscillator signal such that a value of the sawtooth oscillator signal varies between 0 and 360.

4. The phase detector circuitry (10) of claim 3 wherein the edge detection and correction circuitry (20) is configured to provide the edge correction signal such that:
• a value of the edge correction signal is 0 when the edge is a falling edge of the in-phase signal;
• the value of the edge correction signal is 180 when the edge is a rising edge of the in-phase signal;
• the value of the edge correction signal is 90 when the edge is a falling edge of the quadrature signal; and
• the value of the edge correction signal is 270 when the edge is a rising edge of the quadrature signal.

5. The phase detector circuitry (10) of claim 1 wherein the in-phase signal and the quadrature signal are components of a wireless communication signal.

6. The phase detector circuitry (10) of claim 5 wherein the wireless communication signal is a hard-limited signal.

7. A method, implemented in phase detector circuitry for estimating phase, comprising:
• receiving (100) an in-phase signal and a quadrature signal by edge detection and correction circuitry;
• generating (102) a sawtooth oscillator signal by oscillator circuitry;
• sampling (104) the sawtooth oscillator signal at each edge of the in-phase signal and the quadrature signal by sampler circuitry, which is coupled to the oscillator circuitry and the edge detection and correction circuitry; and
• compensating (106) the sampled sawtooth oscillator signal by adder circuitry based on whether the edge is in the in-phase signal or the quadrature signal and whether the edge is a rising edge or a falling edge to provide a phase estimate signal, wherein the adder circuitry is coupled to the sampler circuitry and the edge detection and correction circuitry.

8. The method of claim 7 further comprising averaging (110) a plurality of phase estimate signals to provide an average phase estimate signal by averaging circuitry, which is coupled to the adder circuitry.

9. The method of claim 7 wherein generating (102) the sawtooth oscillator signal comprises generating the sawtooth oscillator signal such that a value thereof varies between 0 and 360.

10. The method of claim 7 wherein compensating (106) the sampled sawtooth oscillator signal based on whether the edge is in the in-phase signal or the quadrature signal and whether the edge is a rising edge or a falling edge to provide a phase estimate signal comprises:
• not changing a value of the sampled sawtooth oscillator signal when the edge is a falling edge of the in-phase signal;
• subtracting 180 from the sampled sawtooth oscillator signal when the edge is a rising edge of the in-phase signal;
• subtracting 90 from the sampled sawtooth oscillator signal when the edge is a falling edge of the quadrature signal; and
• subtracting 270 from the sampled sawtooth oscillator signal when the edge is a rising edge of the quadrature signal.

11. The method of claim 7 wherein the in-phase signal and the quadrature signal are components of a wireless communication signal.

12. The method of claim 11 wherein the wireless communication signal is a hard-limited signal.

## Patentansprüche

1. Phasendetektorschaltung (10), die konfiguriert ist, um eine Phase eines Signals zu messen, wobei die Phasendetektorschaltung (10) Folgendes umfasst:
• Oszillatorschaltung (12), die konfiguriert ist, um ein Sägezahnoszillatorsignal (OSCₛₜ) bereitzustellen;
• Flankendetektions- und korrekturschaltung (20, die für Folgendes konfiguriert ist:
• Empfangen eines phasengleichen Signals (Iᵢₙ) und eines Quadratursignals (Qᵢₙ);
• Bereitstellen eines Flankendetektionssignals (E_{det}) während jeder Flanke des phasengleichen Signals und des Quadratursignals; und
• Bereitstellen eines Flankenkorrektursignals (E_{corr}), wobei das Flankenkorrektursignal darauf basiert ist, ob die Flanke in dem phasengleichen Signal oder in dem Quadratursignal ist und ob die Flanke eine ansteigende Flanke oder eine abfallende Flanke ist;
• Abtastschaltung (14), die mit der Oszillatorschaltung und der Flankendetektionsund korrekturschaltung gekoppelt ist, wobei die Abtastschaltung konfiguriert ist, um das Sägezahnoszillatorsignal als Reaktion auf das Flankendetektionssignal abzutasten; und
• Addierschaltung (16), die mit der Abtastschaltung und der Flankendetektions- und korrekturschaltung gekoppelt ist, wobei die Addierschaltung konfiguriert ist, um das Flankenkorrektursignal von dem abgetasteten Sägezahnoszillatorsignal (OSCₛₜ(t)) zu subtrahieren, um ein Phasenschätzsignal (PHₑₛₜ) bereitzustellen.

2. Phasendetektorschaltung (10) nach Anspruch 1, die ferner eine Mittelungsschaltung (18) umfasst, die mit der Addierschaltung (16) gekoppelt und konfiguriert ist, um eine Anzahl von Phasenschätzsignalen zu empfangen und zu mitteln, um ein durchschnittliches Phasenschätzsignal (AVG(PHₑₛₜ) bereitzustellen.

3. Phasendetektorschaltung (10) nach Anspruch 1, wobei die Oszillatorschaltung (12) konfiguriert ist, um das Sägezahnoszillatorsignal derart bereitzustellen, dass ein Wert des Sägezahnoszillatorsignals zwischen 0 und 360 variiert.

4. Phasendetektorschaltung (10) nach Anspruch 3, wobei die Flankendetektions- und korrekturschaltung (20) konfiguriert ist, um das Flankenkorrektursignal derart bereitzustellen, dass:
• ein Wert des Flankenkorrektursignals 0 beträgt, wenn die Flanke eine abfallende Flanke des phasengleichen Signals ist;
• der Wert des Flankenkorrektursignals 180 beträgt, wenn die Flanke eine ansteigende Flanke des phasengleichen Signals ist;
• der Wert des Flankenkorrektursignals 90 beträgt, wenn die Flanke eine abfallende Flanke des Quadratursignals ist; und
• der Wert des Flankenkorrektursignals 270 beträgt, wenn die Flanke eine ansteigende Flanke des Quadratursignals ist.

5. Phasendetektorschaltung (10) nach Anspruch 1, wobei das phasengleiche Signal und das Quadratursignal Komponenten eines Drahtloskommunikationssignals sind.

6. Phasendetektorschaltung (10) nach Anspruch 5, wobei das Drahtloskommunikationssignal ein hartbegrenztes Signal ist.

7. Verfahren, das in einer Phasendetektorschaltung zum Schätzen einer Phase implementiert ist, das Folgendes umfasst:
• Empfangen (100) eines phasengleichen Signals und eines Quadratursignals durch Flankendetektions- und korrekturschaltung;
• Erzeugen (102) eines Sägezahnoszillatorsignals durch eine Oszillatorschaltung;
• Abtasten (104) des Sägezahnoszillatorsignals an jeder Flanke des phasengleichen Signals und des Quadratursignals durch eine Abtastschaltung, die mit der Oszillatorschaltung und der Flankendetektions- und korrekturschaltung gekoppelt ist; und
• Ausgleichen (106) des abgetasteten Sägezahnoszillatorsignals durch die Addierschaltung basierend darauf, ob die Flanke in dem phasengleichen Signal oder in dem Quadratursignal ist und, ob die Flanke eine ansteigende Flanke oder eine abfallende Flanke ist, um ein Phasenschätzsignal bereitzustellen, wobei die Addierschaltung mit der Abtastschaltung und der Flankendetektions- und korrekturschaltung gekoppelt ist.

8. Verfahren nach Anspruch 7, das ferner ein Mitteln (110) mehrerer Phasenschätzsignale umfasst, um ein durchschnittliches Phasenschätzsignal durch die Mittelungsschaltung bereitzustellen, die mit der Addierschaltung gekoppelt ist.

9. Verfahren nach Anspruch 7, wobei ein Erzeugen (102) des Sägezahnoszillatorsignals das Erzeugen des Sägezahnoszillatorsignals derart umfasst, dass ein Wert davon zwischen 0 und 360 variiert.

10. Verfahren nach Anspruch 7, wobei das Ausgleichen (106) des abgetasteten Sägezahnoszillatorsignals basierend darauf, ob die Flanke in dem phasengleichen Signal oder in dem Quadratursignal ist und, ob die Flanke eine ansteigende Flanke oder eine abfallende Flanke ist, um ein Phasenschätzsignal bereitzustellen, Folgendes umfasst:
• nicht Ändern eines Werts des abgetasteten Sägezahnoszillatorsignals, wenn die Flanke eine abfallende Flanke des phasengleichen Signals ist;
• Subtrahieren von 180 von dem abgetasteten Sägezahnoszillatorsignal, wenn die Flanke eine ansteigende Flanke des phasengleichen Signals ist;
• Subtrahieren von 90 von dem abgetasteten Sägezahnoszillatorsignal, wenn die Flanke eine abfallende Flanke des Quadratursignals ist; und
• Subtrahieren von 270 von dem abgetasteten Sägezahnoszillatorsignal, wenn die Flanke eine ansteigende Flanke des Quadratursignals ist.

11. Verfahren nach Anspruch 7, wobei das phasengleiche Signal und das Quadratursignal Komponenten eines Drahtloskommunikationssignals sind.

12. Verfahren nach Anspruch 11, wobei das Drahtloskommunikationssignal ein hartbegrenztes Signal ist.

## Revendications

1. Circuiterie (10) de détection de phase configurée pour mesurer une phase d'un signal, la circuiterie (10) de détection de phase comprenant :
• une circuiterie (12) oscillatrice configurée pour fournir un signal d'oscillateur en dent de scie (OSCₛₜ) ;
• une circuiterie (20) de détection et de correction de front configurée pour :
• recevoir un signal en phase (Iᵢₙ) et un signal en quadrature (Qᵢₙ) ;
• fournir un signal de détection de front (E_{det}) pendant chaque front du signal en phase et du signal en quadrature ; et
• fournir un signal de correction de front (E_{corr}), le signal de correction de front étant basé sur le fait de savoir si le front est dans le signal en phase ou le signal en quadrature et si le front est un front montant ou un front descendant ;
• une circuiterie (14) d'échantillonnage couplée à la circuiterie oscillatrice et à la circuiterie de détection et de correction de front, la circuiterie d'échantillonnage étant configurée pour échantillonner le signal d'oscillateur en dent de scie en réponse au signal de détection de front ; et
• une circuiterie (16) de sommation couplée à la circuiterie d'échantillonnage et à la circuiterie de détection et de correction de front, la circuiterie de sommation étant configurée pour soustraire le signal de correction de front du signal d'oscillateur en dent de scie échantillonné (OSCₛₜ(t)) pour fournir un signal d'estimation de phase (PHest).

2. Circuiterie (10) de détection de phase selon la revendication 1, comprenant en outre une circuiterie (18) d'établissement de moyenne couplée à la circuiterie (16) de sommation et configurée pour recevoir et établir la moyenne d'un nombre de signaux d'estimation de phase afin de fournir un signal d'estimation de phase moyen (AVG(PHₑₛₜ)).

3. Circuiterie (10) de détection de phase selon la revendication 1, la circuiterie (12) oscillatrice étant configurée pour fournir le signal d'oscillateur en dent de scie de telle sorte qu'une valeur du signal d'oscillateur en dent de scie varie entre 0 et 360.

4. Circuiterie (10) de détection de phase selon la revendication 3, la circuiterie (20) de détection et de correction de front étant configurée pour fournir le signal de correction de front de telle sorte que :
• une valeur du signal de correction de front est de 0 lorsque le front est un front descendant du signal en phase ;
• la valeur du signal de correction de front est de 180 lorsque le front est un front montant du signal en phase ;
• la valeur du signal de correction de front est de 90 lorsque le front est un front descendant du signal en quadrature ; et
• la valeur du signal de correction de front est de 270 lorsque le front est un front montant du signal en quadrature.

5. Circuiterie (10) de détection de phase selon la revendication 1, le signal en phase et le signal en quadrature étant des composantes d'un signal de communication sans fil.

6. Circuiterie (10) de détection de phase selon la revendication 5, le signal de communication sans fil étant un signal soumis à une limitation stricte.

7. Procédé, mis en œuvre dans une circuiterie de détection de phase pour estimer la phase, comprenant :
• la réception (100) d'un signal en phase et d'un signal en quadrature par une circuiterie de détection et de correction de front ;
• la génération (102) d'un signal d'oscillateur en dent de scie par une circuiterie oscillatrice ;
• l'échantillonnage (104) du signal d'oscillateur en dent de scie à chaque front du signal en phase et du signal en quadrature par une circuiterie d'échantillonnage, qui est couplée à la circuiterie oscillatrice et à la circuiterie de détection et de correction de front ; et
• la compensation (106) du signal d'oscillateur en dent de scie échantillonné par une circuiterie de sommation sur la base du fait de savoir si le front est dans le signal en phase ou le signal en quadrature et si le front est un front montant ou un front descendant pour fournir un signal d'estimation de phase, la circuiterie de sommation étant couplée à la circuiterie d'échantillonnage et à la circuiterie de détection et de correction de front.

8. Procédé selon la revendication 7, comprenant en outre le l'établissement de la moyenne (110) d'une pluralité de signaux d'estimation de phase pour fournir un signal d'estimation de phase moyen par une circuiterie d'établissement de moyenne, laquelle est couplée à la circuiterie de sommation.

9. Procédé selon la revendication 7, la génération (102) du signal d'oscillateur en dent de scie comprenant la génération du signal d'oscillateur en dent de scie de telle sorte qu'une valeur de celui-ci varie entre 0 et 360.

10. Procédé selon la revendication 7, la compensation (106) du signal d'oscillateur en dent de scie échantillonné sur la base du fait de savoir si le front est dans le signal en phase ou le signal en quadrature et si le front est un front montant ou un front descendant pour fournir un signal d'estimation de phase comprenant :
• le non-changement d'une valeur du signal d'oscillateur en dent de scie échantillonné lorsque le front est un front descendant du signal en phase ;
• la soustraction de 180 du signal d'oscillateur en dent de scie échantillonné lorsque le front est un front montant du signal en phase ;
• la soustraction de 90 du signal d'oscillateur en dent de scie échantillonné lorsque le front est un front descendant du signal en quadrature ; et
• la soustraction de 270 du signal d'oscillateur en dent de scie échantillonné lorsque le front est un front montant du signal en quadrature.

11. Procédé selon la revendication 7, le signal en phase et le signal en quadrature étant des composantes d'un signal de communication sans fil.

12. Procédé selon la revendication 11, le signal de communication sans fil étant un signal soumis à une limitation stricte.
